# EUROPÄISCHE PATENTSCHRIFT

(11) **EP 2 162 570 B1**
(45) Veröffentlichungstag und Bekanntmachung des Hinweises auf die Patenterteilung: **28.03.2012**
(21) Anmeldenummer: 08784554.1
(22) Anmeldetag: 17.06.2008
(51) Int. Cl.: C30B 15/14, C30B 11/00

(54) **VORRICHTUNG ZUR HERSTELLUNG VON KRISTALLEN AUS ELEKTRISCH LEITENDEN SCHMELZEN**
DEVICE FOR PRODUCING CRYSTALS FROM ELECTROCONDUCTIVE MELTS
DISPOSITIF DE PRODUCTION DE CRISTAUX À PARTIR DE BAINS FONDUS ÉLECTRIQUEMENT CONDUCTEURS

(30) Priorität: 18.06.2007 DE 102007028547
(43) Veröffentlichungstag der Anmeldung: 17.03.2010
(73) Patentinhaber: Forschungsverbund Berlin E.V., 12489 Berlin (DE)
(72) Erfinder: LANGE, Ralph-Peter, 17039 Wulkenzin (DE); JOCKEL, Dietmar, 07774 Camburg (DE); ZIEM, Mario, 12459 Berlin (DE); RUDOLPH, Peter, 12529 Schönefeld (DE); KIESSLING, Frank, 10439 Berlin (DE); FRANK-ROTSCH, Christiane, 16727 Oberkämer (DE); CZUPALLA, Matthias, 14513 Teltow (DE); NACKE, Bernard, 31303 Burgdorf (DE); KASJANOW, Helene, 70376 Stuttgart (DE)
(74) Vertreter: Gulde Hengelhaupt Ziebig & Schneider
(86) Internationale Anmeldenummer: PCT/EP2008/005192
(87) Internationale Veröffentlichungsnummer: WO 2008/155138

(56) Entgegenhaltungen:
- DE-A1- 10 349 339
- JP-A- 59 121 183
- JP-A- 2001 181 088
- US-A- 4 963 334
- US-A- 5 141 721
- KIM ET AL: "Versatile magnet assembly for Czochralski silicon crystal growth" IBM TECHNICAL DISCLOSURE BULLETIN, IBM CORP. NEW YORK, US, Bd. 26, Nr. 2, 1983, Seiten 601-603, XP001302195 ISSN: 0018-8689
- KIM J M ET AL: "METHOD FOR INTERRUPT OF MELT ROTATION AND CONTROL OF OXYGEN CONCENTRATION IN CZOCHRALSKI SILICON CRYSTAL GROWTH" IBM TECHNICAL DISCLOSURE BULLETIN, IBM CORP. NEW YORK, US, Bd. 25, Nr. 5, 1. Oktober 1982 (1982-10-01), Seite 2277/2278, XP000611110 ISSN: 0018-8689 in der Anmeldung erwähnt
- KIM ET AL: "Striations in CZ silicon crystals grown under various axial magnetic field strengths" J.APPLIED PHYSICS, Bd. 58, Nr. 7, 1985, Seiten 2731-2735, XP001302174
- HOSHIKAWEA ET AL: "Low oxygen content Czochralski silicon crystal growth" JAPANESE JOURNAL OF APPLIED PHYSICS, Bd. 19, Nr. 1, 1980, Seiten L33-36, XP002502491 in der Anmeldung erwähnt

## Beschreibung

Die Erfindung betrifft eine Vorrichtung zur Herstellung von Kristallen aus elektrisch leitenden Schmelzen.

Es sind Vorrichtungen zur gleichzeitigen Erzeugung eines Temperaturprofils und Magnetfeldes für den Einsatz in der Kristallzüchtung bekannt. Die meisten Veröffentlichungen beschreiben Vorrichtungen zur Erzeugung eines rotierenden (transversalen) Magnetfeldes. In DE 2 107 646, Hull IBM Technical Disclosure Bulletin Vol. 23 (1980) 2756), Hoshikawa et al. (Jpn. J. Appl. Phys. 19 (1980) L33) und Kim et al., IBM Technical Disclosure Bulletin Vol. 25 (1982) 2277 sowie in DE 37 50 382 T2 wird ein den Schmelztiegel umschließender und aus drei Segmenten in Dreieckschaltung bestehender hohlzylindrischer Widerstandsheizer aus Graphit beschrieben, der mit einem RST-Dreiphasenstrom so durchflossen wird, dass die Anordnung neben einer bestimmten Wärmemenge ein transversal rotierendes Magnetfeld erzeugt und somit wie ein Induktionsmotor wirkt, wobei der Heizer als Stator und die von ihm umschlossene elektrisch leitende Schmelze als Rotor fungieren. Dadurch wird in allen drei Fällen eine in einem becherförmigen Kieselglastiegel befindliche Siliciumschmelze, je nach Richtung des Stromflusses, in rechts- oder linksdrehende Rotationsbewegung versetzt. Die Anordnung wird für die Erzeugung einer kontrollierten Konvektion und damit Durchmischung der Schmelze vorgeschlagen.

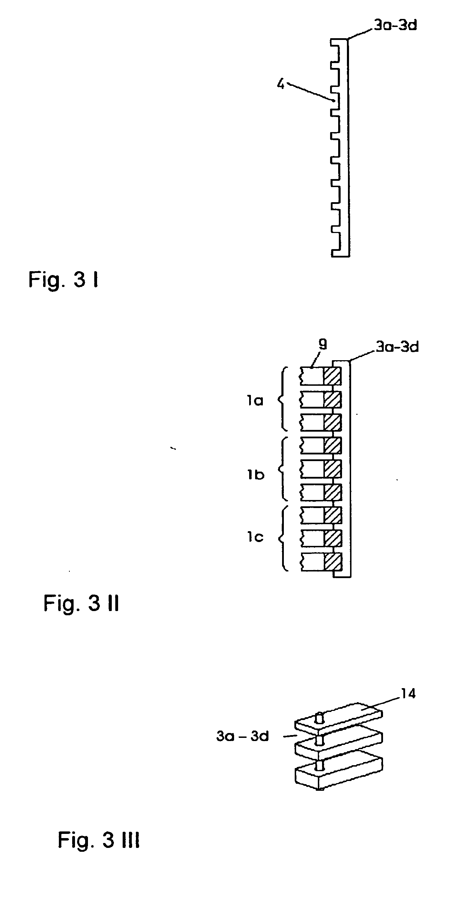

Es finden sich in keinen der oben aufgezählten Schriften Angaben darüber, wie der ein Magnetfeld erzeugende Widerstandsheizkörper detailliert gestaltet ist. Würde die üblicherweise in der Kristallzüchtung verwendete mäanderförmig vertikal geschlitzte Form zur Vergrößerung des Stromweges und damit des elektrischen Widerstandes verwendet werden (vgl. z. B. Abb. 3.2.-24 auf S. 703 in K. Wilke, J. Bohm, Kristallzüchtung, Vlg. H. Deutsch and Thun, Frankfurt a.M. 1988), wäre die Einkopplung des Magnetfeldes auf die an den Kontaktpunkten anliegende Phasenverschiebung beschränkt und somit uneffektiv, da sich die Feldlinien im Bereich der entgegenlaufenden Strombahnen aufheben. Ein geringer longitudinaler Feldanteil würde am oberen und unteren Rand mit den waagerecht verlaufenden Abschnitten der Strombahnumkehr entstehen.

Um hinsichtlich der magnetischen Induktion eine effektivere Gestaltung der Strombahnen und eine Sternschaltung des Heizkörpers zu erzielen, wird in DE 2 107 646 vorgeschlagen, eine spiralenförmige dreifach parallele Schlitzung zu verwenden, die beginnend von den Kontaktpunkten am Heizerboden wendelförmig aufsteigt und nahe des oberen Randes endet.

In JP 59121183 A wird empfohlen, zwei gegenüberstehende zylindrisch gekrümmte Heizsegmente, die je aus einer Leiterbahnspirale mit Spiralart in der Segmentmitte bestehen und ein konstantes Magnetfeld zur Unerdrückung der Konvektionsflüsse in der Schmelze erzeugen. Eine solche Anordnung ist jedoch in thermischer und magnetischer Hinsicht äußerst unsymmetrisch, für eine Einkristallzüchtung nachteilig und zudem wegen der Kompliziertheit für einen industriellen Einsatz ungeeignet. JP 2001 181 088 offenbart eine Induktionsheizeinrichtung. Bei dieser Vorrichtung sind die Stronzuführungsschienen in Form eines Winkelteiles ausgestallet.

Für eine wirkungsvollere Dämpfung der Konvektionsströme in einem Kristallschmelztiegel ist die Einkopplung eines longitudinal wandernden Magnetfeldes besonders vorteilhaft, da es in Form eines geschlossenen Feldlinientoroids dem formähnlichen achsensymmetrischen Strömungsmuster der Schmelze entgegenwirkt (vgl. z. B. Socoliuc, Magnetohydrodynamics 39 (2003) 187) und dadurch auch eine sehr gute Kontrolle der fest-flüssig-Phasengrenzform beim vertikalen Bridgmanverfahren ermöglicht (vgl. z. B. Schwesig et al. J. Crystal Growth 266 (2004) 224). Alle oben diskutierten Lösungen erfüllen diese Anforderung nicht.

Es werden aber auch Heizeranordnungen beschrieben, die gleichzeitig Wärme und ein longitudinales magnetisches Wanderfeld erzeugen. So wird in DE 10102126 A1 auf eine rotationssymmetrische Heizeranordnung verwiesen, die simultan als spiralförmiger Mehrphaseninduktor ausgebildet ist. Auch in DE 103 49 339 A1 werden drei übereinander befindliche Heizspulenabschnitte aus spiralförmigen elektrisch leitenden Windungen aus Graphit ausgeführt und in Dreieckkonfiguration miteinander verschaltet, so dass bei Durchfluss der um 120° phasenverschobenen RST Wechselspannung in die umschlossene Schmelze toroidal wandernde Magnetfeldlinien induziert werden. Bekannt ist, dass mindestens eine Zweispulenanordnung für die kombinierte Erzeugung eines Wärme- und magnetischen Wanderfeldes vorhanden sein muss.

All diese aufgeführten Lösungsvorschläge besitzen die folgenden Nachteile: Einerseits sind die geometrischen Parameter der Spulenwindungen, wie der Querschnitt, Abstand und Windungszahl nicht spezifiziert und optimiert, was aber die unbedingte technische Voraussetzung für eine funktionierende gleichzeitige Betreibung der Anordnung zum Aufschmelzen bzw. Kristallisieren einer entsprechenden Substanz und Erzeugung eines magnetischen Wanderfeldes hinreichender Kraft ist und dadurch erst eine industrielle Anwendung ermöglicht. Andererseits sind die in den Veröffentlichungen graphisch dargestellten und erläuterten Heizanordnungen mechanisch instabil, da das Eigengewicht der Windungen zum Zusammensacken und damit zu unterschiedlichen Windungsabständen bis hin zu Kurzschlüssen führen würden. Sie lassen zudem keine gezielte Variation der Windungsabstände für die jeweiligen Spulenabschnitte zu. Ein weiterer Nachteil besteht darin, dass die in den Stromzuführungsschienen zu den elektrischen Kontaktpunkten der Spulenabschnitte, z. B. vier bei einer Sternschaltung, jeweils auf einem bestimmten Kreiswinkel koaxial in unmittelbarer Nähe der äußeren Mantelfläche der Anordnung entlang geführt sind, wodurch es wegen deren Induktionsbeiträge zu Asymmetrien des eingekoppelten Magnetfeldes kommt, was wiederum einer bei Kristallzüchtungsprozessen geforderten Rotationssymmetrie der Wärme- und Massefelder in der Schmelze widerspricht. Außerdem wird keine technische Lösungen hinsichtlich der Kontaktzuführungen für eine Sternschaltung aufgezeigt.

Aufgabe der Erfindung ist es, eine Vorrichtung zur Herstellung von Kristallen, Einkristallen wie Polykristallen, aus elektrisch leitenden Schmelzen bereitzustellen, mit der der Züchtungsprozess und damit die Qualität der herzustellenden Kristalle verbessert wird, insbesondere durch Verbesserung der mechanischen Stabilität der Heizeinrichtung und in Verbindung mit der Vermeidung eines unsymmetrischen magnetisches Zusatzfeldes mit störender Wirkung in der Schmelze.

Die Aufgabe wird gelöst durch eine Vorrichtung mit den Merkmalen des Anspruches 1.

Vorteilhafte Ausgestaltungen der erfindungsgemäßen Vorrichtung sind in den Unteransprüchen enthalten.

So ist die erfindungsgemäße Vorrichtung zur Herstellung von Kristallen aus elektrisch leitenden Schmelzen, mindestens aufweisend einen in einer Züchtungskammer angeordneten, eine Schmelze enthaltenen Tiegel, eine den Tiegel umgebende Heizeinrichtung, welche als Mehrspulenanordnung von übereinander angeordneten Spulen ausgeführt ist, wobei die Spulen stufenförmige oder stufenlose Spulenwindungen aufweisen und an den Spulen Stromzuführungsschienen angebracht sind, die elektrisch mit einer außerhalb der Züchtungskammer angeordneten Energieversorgungseinrichtung verbunden sind, dadurch gekennzeichnet, dass
die Heizeinrichtung Stabilisierungselemente an den Spulenwindungen aufweist und die Stromzuführungsschienen in Form eines Winkelteiles ausgestaltet sind.

In einer bevorzugten Ausführungsform der erfindungsgemäßen Vorrichtung ist vorgesehen, dass die Stabilisierungselemente als zylindrische Stäbe mit nutförmigen Einkerbungen ausgestaltet sind.

In einer anderen bevorzugten Ausführungsform der erfindungsgemäßen Vorrichtung ist vorgesehen, dass, die Stabilisierungselemente als zylindrische Stäbe mit Plättchen ausgestaltet sind.

In einer weiteren bevorzugten Ausführungsform der erfindungsgemäßen Vorrichtung ist vorgesehen, dass die Stabilisierungselemente koaxial entlang der Spulenaußenseite zwischen den Stromzuführungsschienen angeordnet sind, wobei die nutförmigen Einkerbungen in die Spulenwindungen der Spulen greifen oder die Plättchen zwischen den Spulenwindungen liegen.

Eine nächste bevorzugte Ausführungsform der erfindungsgemäßen Vorrichtung sieht vor, dass mindestens zwei Stabilisierungselemente vorhanden sind.

Durch das Anbringen der Stabilisierungselemente wird ein wesentlicher Nachteil aller bisher bestehenden Anordnungen, nämlich das Zusammensacken der mechanisch instabilen Heizerwindungen, vermieden und ein weiterer Parameter zur Beeinflussung des thermischen und des magnetischen Feldes, nämlich variierende oder gleichbleibende Abstände zwischen den einzelnen Windungen, gegeben.

Eine weitere bevorzugte Ausführungsform der erfindungsgemäßen Vorrichtung ist dadurch gekennzeichnet, dass mindestens eine nutförmige Einkerbung an den Stabilisierungselementen vorhanden ist.

In einer weiteren bevorzugten Ausführungsform der erfindungsgemäßen Vorrichtung ist vorgesehen, dass die Stabilisierungselemente mindestens ein Plättchen aufweisen.

Die erfindungsgemäße Vorrichtung ist dadurch gekennzeichnet, dass die Stromzuführungsschienen mindestens eine horizontale Schiene und eine vertikale Schiene aufweisen, wobei diese zueinander in Form eines Winkelteiles miteinander verbunden sind.

Die erfindungsgemäße Vorrichtung sieht vor, dass die Schienenlänge der horizontalen Schienen mindestens der Länge der Eindringtiefe des magnetischen Flusses bei einer jeweiligen verwendeten Frequenz entspricht.

Mit dieser Anordnung wird eine Induktion von Strömen, die aus dem Stromfluss der vertikalen Stromzuführungen in der Schmelze, welche zu Asymmetrien des mit dem Spulenheizer erzeugten Flusses führen würde, verhindert.

In der erfindungsgemäßen Vorrichtung ist vorgesehen, dass die horizontale Schiene der Stromzuführungsschienen mit mindestens einer Spule elektrisch leitend verbunden ist.

Die horizontale Schiene der Stromzuführungsschienen ist mit zwei Spulen elektrisch leitend verbunden, wenn sie als Sternpunkt im Falle einer Sternschaltung fungiert.

Eine andere bevorzugte Ausführungsform der erfindungsgemäßen Vorrichtung sieht vor, dass die vertikalen Schienen der Stromzuführungsschienen außerhalb der Züchtungskammer mit der Energieversorgungseinrichtung elektrisch leitend verbunden sind.

Die vertikale Schiene der Stromzuführungsschienen kontaktiert zunächst eine vakuum- und druckdichte Kesseldurchführung elektrisch leitend und ist danach außerhalb der Züchtungskammer mit der Energieversorgungseinrichtung elektrisch leitend verbunden.

Eine nächste bevorzugte Ausführungsform der erfindungsgemäßen Vorrichtung ist dadurch gekennzeichnet, dass eine Stromzuführungsschiene zwei horizontale Schienen aufweist, die mit den Spulen elektrisch verbunden sind.

Damit wird erreicht, dass eine Stromzuführung den Stempunkt von zwei einander angrenzenden Spulen darstellt, wodurch eine Zuführung eingespart wird. Eine Spule wird elektrisch so verschaltet, dass eine identische Feldrichtung zu den anderen Spulen erhalten wird.

In einer anderen bevorzugten Ausgestaltung der erfindungsgemäßen Vorrichtung ist vorgesehen, dass die Spulenwindungen (9) einen Windungsquerschnitt (Q) mit einer Windungsbreite (B) und einer Windungshöhe (H) im Verhältnis von 10:1 bis 1:10 aufweisen.

Eine weitere bevorzugte Ausführungsform der erfindungsgemäßen Vorrichtung ist dadurch gekennzeichnet, dass die Spulenwindungen einen Windungsquerschnitt mit der Windungsbreite und der Windungshöhe im Verhältnis von 5:1 aufweisen.

Die Geometrie der Spulenwindungen wird erfindungsgemäß auf ihre Stabilität und auf ihren spezifischen Widerstand abgestimmt.

Eine nächste bevorzugte Ausgestaltung der erfindungsgemäßen Vorrichtung sieht vor, dass der Windungsquerschnitt (Q) eine beliebige geometrische Form aufweist.

Mit der erfindungsgemäßen Lösung werden die aufgezeigten Nachteile des Standes der Technik vermieden: Die Stabilisierungselemente sorgen dafür, dass über die gesamte Länge der Heizeinrichtung bzw. einer Spulenlänge der Windungsabstand mechanisch stabil und konstant oder stabil und aufweitend bzw. verringernd zur Einstellung eines Temperaturgradienten gehalten wird.

Die spiral- oder stufenförmig aufsteigenden Strombahnen, die die Spulen der hohlzylindrischen Heizeinrichtung aus Reinstgraphit bilden, weisen einen solchen Windungsquerschnitt und solche Windungsabstände auf, dass bei Stromdurchfluss bestimmter Stärke einerseits die Schmelztemperatur der jeweiligen Züchtungssubstanz erreicht bzw. bis zu ca. 100 °C überschritten und andererseits mit gleicher Stromstärke aber optimierter Phasenverschiebung (Phasenwinkel) und Frequenz des Drehstromes ein magnetisches Wanderfeld mit einer solchen Induktionsstärke und Feldlinienkraft erzeugt wird, die der Flusskraft der Konvektionsströme in der Schmelzen entgegengerichtet ist, diese aufhebt bzw. umkehrt oder der Flusskraft der Konvektionsströme in der Schmelze gleichgerichtet ist und diese verstärkt.

Die erfindungsgemäße Vorrichtung kann in denjenigen Kristallzüchtungsanlagen eingesetzt werden, die nach dem Czochralski-Verfahren, der vertikalen Bridgman- bzw. Gradient-Freeze-Methode, aber auch nach dem Kyropolus- und Heat-Exchanger-Verfahren arbeiten. Weiterhin ist diese Vorrichtung - neben der Züchtung von Einkristallen - auch zur Herstellung von polykristallinem Halbleitermaterial geeignet.

Es hat sich gezeigt, dass eine Optimierung im Vorfeld der Anfertigung der erfindungsgemäßen Vorrichtung mit Hilfe einer numerischen Modellierung erfolgen kann, über die zunächst die Konfiguration und Flusskraft der Konvektion berechnet und anschließend unter Vorgabe der für die Züchtung gesetzten Heizleistung, d. h. des Heizstromes, und der Heizspannung, die Geometrie und der Abstand der Windungen sowie Frequenz und Phasenverschiebung des Drehstromes so ermittelt wird, dass die o.g. Wirkung bestmöglich erzielt wird.

Die thermische und magnetische Rotationssymmetrie der Vorrichtung wird erfindungsgemäß dadurch gewährleistet, dass die Stromzuführungsschienen an den Kontaktpunkten der Spulen erfindungsgemäß nicht achsenparallel entlang der Manteloberfläche der Spulen verlaufen, sondern dass sie als in Form eines Winkelteiles "kranförmig" gestaltet sind und somit den Strom über waagerechte Ausleger, den horizontalen Schienen der Stromzuführungsschienen, zuführen. Die Stromzuführungsschienen sind erst nach einer unkritischen Distanz, diese beträgt mindestens die Eindringtiefe des magnetischen Flusses bei der verwendeten Frequenz, abgewinkelt und mit den Durchführungen der Züchtungskammer verbunden.

Im folgenden wird ein Ausführungsbeispiel der Erfindung anhand von Zeichnungen näher erläutert.

Es zeigen
- Fig. 1:: einen schematischen Querschnitt durch eine Kristallzüchtungsanlage,
- Fig. 2: eine schematische Darstellung der Heizeinrichtung der Kristallzüchtungsanlage,
- Fig. 3 I: eine schematische Darstellung von Stabilisierungselementen mit nutförmigen Einkerbungen,
- Fig. 3 II: eine schematische Darstellung der Stabilisierungselemente mit nutförmigen Einkerbungen und den anliegenden Spulenwindungen,
- Fig. 3 III: eine schematische Darstellung der Stabilisierungselemente mit Plättchen.

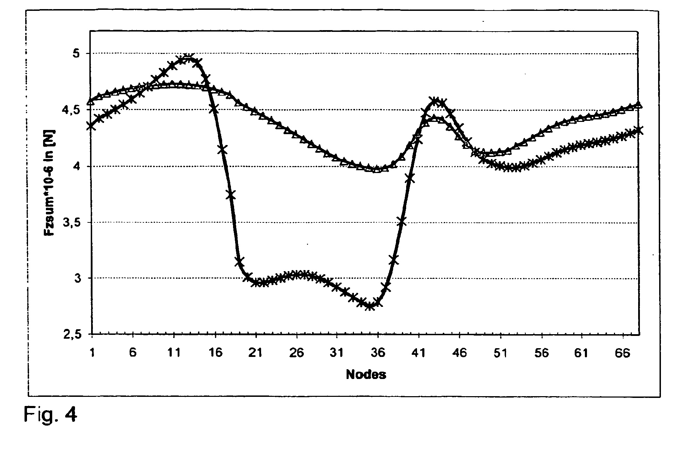

- Fig. 4: eine grafische Darstellung der Verteilung der vertikalen magnetischen Kraftkomponente in Abhängigkeit von der Geometrie der Stromzuführungsschienen.

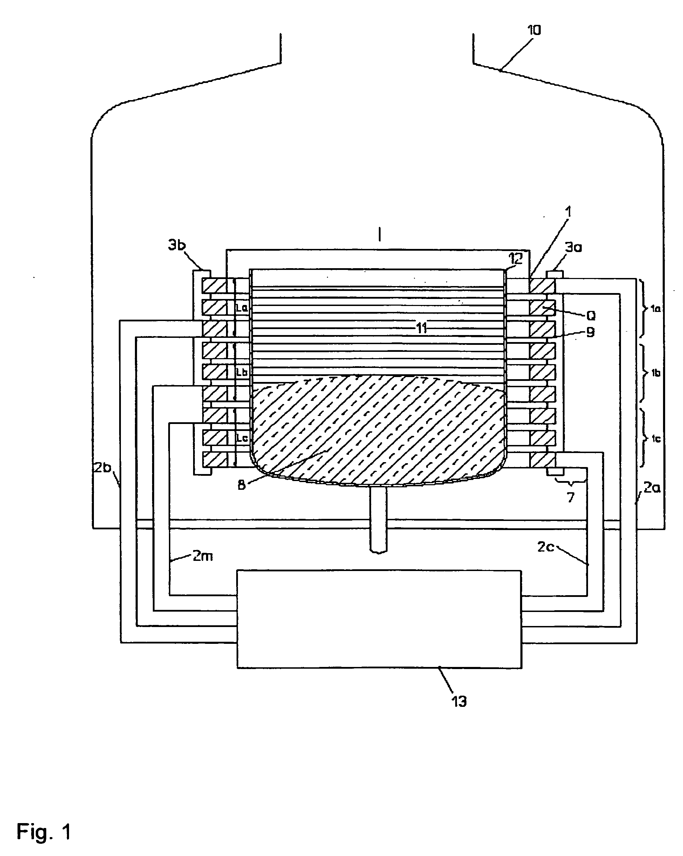

In Fig. 1 wird die schematische Darstellung einer Kristallzüchtungsanlage im Querschnitt gezeigt.

In einer Züchtungskammer 10 befindet sich ein Tiegel 12, der eine Schmelze 11 enthält. Der Tiegel 12 wird von einer Heizeinrichtung 1 umgeben. Gezeigt wird auch ein aus der Schmelze 11 erstarrter Kristall 8.

Die Heizeinrichtung 1 ist aus drei übereinander angeordneten Spule 1a, 1b, 1c aufgebaut. Die Spulenwindungen 9 der Spulen 1a, 1b, 1c weisen einen Windungsquerschnitt Q auf. Die Spulen 1a, 1b, 1c haben jeweils eine Spulenlänge Lₐ, L_{b}, L_{c}. An den Spulen 1a, 1b, 1c befinden sich elektrisch leitende Stromzuführungsschienen 2a,2b, 2c und 2m, die durch die Züchtungskammer 10 geführt und mit einer Energieversorgungseinrichtung 13 elektrisch verbunden sind. Fig. 1 zeigt auch die zwischen den Stromzuführungsschienen 2a, 2b, 2d, 2m angeordneten Stabilisierungselemente 3a, 3b, 3c, 3d.

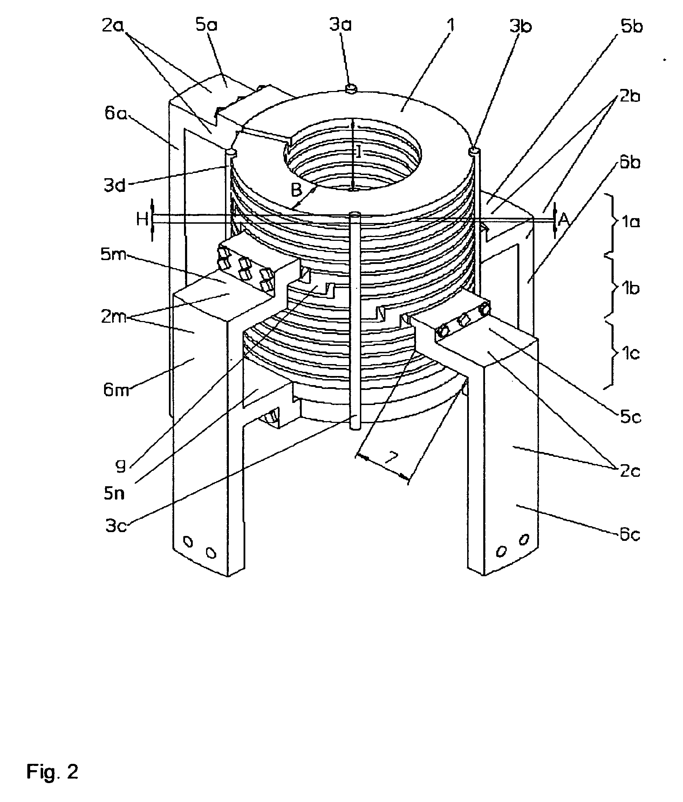

Fig. 2 zeigt eine schematische Darstellung der Heizeinrichtung für eine Kristallzüchtungsanlage.

Die Heizeinrichtung 1 besteht aus einer Mehrspulenanordnung mit drei übereinander angeordneten Spulen 1a, 1b, 1c aus Graphit, die stufenförmige Spulenwindungen 9 aufweisen. An den Spulen 1a, 1b, 1 c der Heizeinrichtung 1 sind vier Stabilisierungselemente 3a, 3b, 3c, 3d, die als Distanzhaltestäbe fungieren, im Winkel von 90° jeweils zwischen den Stromzuführungsschienen 2a, 2b, 2c, 2m angeordnet. Die Spulenwindungen 9 der Spulen 1a, 1b, 1c weisen eine Windungsbreite B, eine Windungshöhe H und einen Windungsabstand A auf. Die Spulen 1a, 1b, 1c sind über die Stromzuführungsschienen 2a, 2b, 2c, 2m so miteinander verschaltet, dass sie strommäßig eine Sternkonfiguration ergeben.

Die Stromzuführungsschienen 2a, 2b, 2c und 2m sind in Form eines Winkelteiles, d. h. "kranförmig" ausgebildet. Sie weisen jeweils mindestens eine horizontale Schiene 5a, 5b, 5c, 5m und eine vertikale Schiene 6a, 6b, 6c, 6m auf, die nahtlos miteinander im rechten Winkel verbunden sind. Die horizontale Schiene 5a, 5b, 5c, 5m ist mit den Kontakten der Spulen 1a, 1b, 1c elektrisch verbunden. Die Schienenlänge 7 der horizontalen Schienen 5a, 5b, 5c, 5m entspricht mindestens der Eindringtiefe des magnetischen Flusses bei der verwendeten Frequenz des Dreiphasenwechselstromes, d. h. die als Winkelteil ausgestaltete Stromzuführungsschienen 2a, 2b, 2c, 2m werden erst nach einer kritischen Distanz zu den Spulen 1a, 1b, 1c der Heizeinrichtung 1 von mindestens der Eindringtiefe des magnetischen Flusses bei der verwendeten Frequenz abgewinkelt. Die Stromzuführungsschienen 2a, 2b und 2c kontaktieren so die Spulenendpunkte. Die mit zwei horizontalen Schienen 5m, 5n versehene Stromzuführungsschiene 2m bildet den gemeinsamen Mittelpunktkontakt der Sternschaltung.

Die Spulen 1 a, 1 b, 1 c sind an eine Wechselspannungsquelle als Energieversorgungseinrichtung 13 angeschlossen. Möglich ist eine Dreieckschaltung oder eine Sternschaltung. Bei einer Dreiecksschaltung entfällt die horizontale Schiene 5m.

Eine Sternschaltung hat den Vorteil einer freien Wahl der Phasenverschiebung. Dazu muss der gemeinsame Mittelpunkt herausgeführt werden.

Die vier Stabilisierungselemente 3a, 3b, 3c, 3d aus Hochtemperaturkeramik unterstützen die mechanische Stabilität der Heizeinrichtung 1 und sorgen für äquidistante oder variable Windungsabstände A. Auf diese Weise wird der Windungsabstand A der Spulenwindungen 9 der Spulen 1 a, 1 b, 1 c flexibel beeinflussbar gehalten.

Ein Innendurchmesser I der Heizeinrichtung 1 beträgt 130 mm und ermöglicht die Umschließung des Tiegels 12 kleinerer Außenabmessung. Bei Durchfluss eines Dreiphasenstromes bestimmter Frequenz und Phasenverschiebung wird je nach Drehrichtung eine Auf- oder Abwärtsbewegung der magnetischen Wanderfeldlinien in der Schmelze 11 erzielt.

Die geometrischen Maße der Spulenwindungen 9, namentlich die Windungshöhe H, die Windungsbreite B und der Windungsabstand A, werden mit Hilfe einer numerischen Modellierung so gefertigt, dass die in die Schmelze eingekoppelte Induktion und Stärke der magnetischen Feldlinien die für die Hemmung der Konvektion erforderliche Gegenkraft erzeugt. Gleichzeitig muss eine Spulenlänge Lₐ, L_{b}, L_{c} pro Spule 1a, 1b, 1c und ein Windungsquerschnitt Q der Spulenwindungen 9 einen solchen Widerstand ergeben, dass bei Stromdurchgang bestimmter Stärke die erforderliche Wärme zum Schmelzen erzeugt wird.

Dazu muss die benötigte Energie in kW bekannt sein. Mit dem nötigen Strom für die Erzeugung eines entsprechend großen magnetischen Flusses kann dann nach dem Ohmschen Gesetz der Querschnitt der Spulen berechnet werden.

Fig. 3 I bis Fig. 3 III zeigen in schematischer Darstellung die Stabilisierungselemente 3a, 3b, 3c, 3d aus Hochtemperaturkeramik.

So wird in Fig. 3 I die schematische Darstellung der Stabilisierungselemente 3a, 3b, mit nutförmige Einkerbungen 4 dargestellt. Die nutförmigen Einkerbungen 4 weisen solche Abmaße auf, das diese in die Spulenwindungen 9 der Spulen 1a, 1b, 1c passen. Auf diese Weise wird der Spulenabstand A der Spulen 1 a, 1 b, 1 c beeinflusst. Die Stabilisierungselemente 3a, 3b, 3c, 3d wirken als Distanzhaltestäbe zwischen den Windungen. Fig. 3 II zeigt, wie die Spulenwindungen 9 der Spulen 1a, 1b, 1c in die nutförmigen Einkerbungen 4 der Stabilisierungselemente 3a, 3b, 3c, 3d greifen.

Fig. 3 III zeigt eine andere Ausgestaltung der Stabilisierungselemente 3a, 3b, 3c, 3d in Form von Plättchen 14 aus Korund, die auf einen zylindrischen Stab geschoben sind.

Alternativ können die nutförmigen Einkerbungen 4 durch diese Plättchen 14 aus entsprechendem Material auf die Stäbe geschoben und zwischen den Windungen platziert werden. Diese Plättchen 14 können gleiche aber auch verschiedene Dicken besitzen und somit ebenfalls eine Variation der Windungsabstände ermöglichen. Eine Fixierung der Plättchen 14 durch die Stabilisierungselemente 3a, 3b, 3c, 3d ist notwendig um die, durch die Vibration des Heizers ausgelöste Bewegung, zu begrenzen.

In Tabelle 1 werden die Ergebnisse von Berechnungen zu Frequenz, Phasenverschiebung und zur Geometrie der Spulenwindungen 9 sowie zur erzeugten elektrischen Leistung für drei wichtige Halbleitermaterialien: Germanium (Ge), Galliumarsenid (GaAs) und Galliumantimonid (GaSb), aufgezeigt. Für die Messungen und Berechnungen der Größen wurde eine vertikale Bridgman-Züchtungsapparatur (VGF - Vertical Gradient Freeze) verwendet. Zum Aufschmelzen der Materialien Ge, GaAs und GaSb wird ein Strom von 450 A und eine Leistung um 6 kW in die Heizeinrichtung 1 eingespeist. Die magnetische Induktion liegt im Bereich um 4 mT - 5 mT. Aus den Optimierungsberechnungen ergeben sich für alle drei Materialien die folgenden Spulenparameter der Heizeinrichtung: Windungsbreite B = 50 mm, Windungshöhe H = 10 mm, Windungsabstand A = 4 mm, Spulenlänge Lₐ, L_{b}, L_{c} der Spulen 1a, 1b, 1c = 66 mm. Für eine verlustarme Stromzuleitung müssen die Stromzuführungsschienen 2a, 2b, 2c und 2m mindestens einen Querschnitt von 25 mm x 70 mm aufweisen.

**Tabelle 1:**

| Parameter | Ge | GaAs | GaSb |
|---|---|---|---|
| Frequenz f [Hz] | 250 | 500 | 300 |
| Phasenwinkel N[°] | 60 | 60 | 70 |
| Heizleistung P [kW] | 2,4 | 2,2 | 2,0 |
| Windungsabstand A [mm] | 4 | 4 | 4 |
| Windungsbreite B [mm] | 50 | 50 | 50 |
| Windungshöhe H [mm] | 10 | 10 | 10 |

In Fig. 4 wird die numerische Modellierung der Verteilung der vertikalen magnetischen Kraftkomponente je Volumenelement über den Umfang der Schmelzoberfläche gezeigt. Die Linie mit den Kreuzen als Wertepunkte stellt die magnetische Kraftkomponente F_{z}, bei Verwendung von Stromzuführungsschienen, die koaxial nahe am Mantel der Heizeinrichtung 1 ausgeführt sind, dar. Die Linie mit den Dreiecken als Wertepunkte zeigt die Verteilung der magnetischen Kraftkomponenten bei Verwendung der erfindungsgemäßen als Winkelteil ausgestalteten "kranförmigen" Stromzuführungsschienen 2a, 2b, 2c, 2m.

Aus der Darstellung wird der erhebliche Einfluss des Stromanteils in den Zuführungen auf das eingekoppelte Magnetfeld und dessen Kraftwirkung in der Schmelze ersichtlich. Ohne die erfindungsgemäßen kranförmigen von weit außen zu den Windungen geführten Stromzuführungen wird durch den fließenden Strom in eben diesen Zuführungen ein unerwünschtes Magnetfeld erheblicher Größe erzeugt, welches die Symmetrie des gesamten Aufbaus deutlich stört und über elektronische Maßnahmen nur schwer zu beeinflussen ist. In einem Magnetheizer muss ein bestimmter Strom fließen, damit ein Magnetfeld erzeugt werden kann. Mit Hilfe der erfindungsgemäßen kranförmigen Zuführungen wird eine deutliche bis vollständige Minderung der gezeigte asymmetrischen Auswirkungen erreicht.

### Bezugszeichenliste

- 1: Heizeinrichtung
- 1a: Spule
- 1b: Spule
- 1 c: Spule

- 2a: Stromzuführungsschiene
- 2b: Stromzuführungsschiene
- 2c: Stromzuführungsschiene
- 2m: Stromzuführungsschiene

- 3a: Stabilisierungselement
- 3b: Stabilisierungselement
- 3c: Stabilisierungselement
- 3d: Stabilisierungselement

- 4: nutförmige Einkerbung

- 5a: horizontale Schiene
- 5b: horizontale Schiene
- 5c: horizontale Schiene
- 5m: horizontale Schiene
- 5n: horizontale Schiene

- 6a: vertikale Schiene
- 6b: vertikale Schiene
- 6c: vertikale Schiene
- 6m: vertikale Schiene
- 7: Schienenlänge der horizontalen Schienen
- 8: Kristall
- 9: Spulenwindung
- 10: Züchtungskammer
- 11: Schmelze
- 12: Tiegel
- 13: Energieversorgungseinrichtung
- 14: Plättchen

- A: Windungsabstand
- H: Windungshöhe
- B: Windungsbreite
- n: Windungszahl
- Lₐ: Spulenlänge
- L_{b}: Spulenlänge
- L_{c}: Spulenlänge
- Q: Windungsquerschnitt
- I: Innendurchmesser der Heizeinrichtung

## Patentansprüche

1. Vorrichtung zur Züchtung von Kristallen aus elektrisch leitenden Schmelzen, mindestens aufweisend einen in einer Züchtungskammer (10) angeordneten, eine Schmelze (11) enthaltenen Tiegel (12), eine den Tiegel (12) umgebende Heizeinrichtung (1), welche als Mehrspulenanordnung von übereinander angeordneten Spulen (1a, 1 b, 1c) ausgeführt ist, wobei die Spulen (1 a, 1b, 1 c) stufenförmige oder stufenlose Spulenwindungen (9) aufweisen und an den Spulen (1 a, 1 b, 1 c) Stromzuführungsschienen (2a, 2b, 2c, 2m) angebracht sind, die elektrisch mit einer außerhalb der Züchtungskammer (10) angeordneten Energieversorgungseinrichtung (13) verbunden sind, **dadurch gekennzeichnet, dass** die Heizeinrichtung (1) Stabilisierungselemente (3a), (3b), (3c), (3d) an den Spulenwindungen (9) aufweist und die Stromzuführungsschienen (2a), (2b), (2c), (2m) mindestens eine horizontale Schiene (5a, 5b, 5c, 5m) und eine vertikale Schiene (6a, 6b, 6c, 6m) aufweisen, die miteinander in Form eines Winkelteiles verbunden sind, wobei die horizontale Schiene (5a, 5b, 5c, 5m) mit mindestens einer Spule (1 a, 1 b, 1 c) elektrisch leitend verbunden ist und eine Schienenlänge (7) der horizontalen Schiene (5a, 5b, 5c, 5m) mindestens einer Eindringtiefe des magnetischen Flusses bei einer jeweilig verwendeten Frequenz entspricht.

2. Vorrichtung nach Anspruch 1, **dadurch gekennzeichnet, dass** die Stabilisierungselemente (3a), (3b), (3c), (3d) als zylindrische Stäbe mit nutförmigen Einkerbungen (4) ausgestaltet sind.

3. Vorrichtung nach Anspruch 1 oder 2, **dadurch gekennzeichnet, dass** die Stabilisierungselemente (3a), (3b), (3c), (3d) als zylindrische Stäbe mit Plättchen (14) ausgestaltet sind.

4. Vorrichtung nach Anspruch 1 bis 3, **dadurch gekennzeichnet, dass** die Stabilisierungselemente (3a), (3b), (3c), (3d) koaxial entlang der Spulenaußenseite zwischen den Stromzuführungsschienen (2a), (2b), (2c), (2m) angeordnet sind, wobei die nutförmigen Einkerbungen (4) in die Spulenwindungen (9) der Spulen (1a), (1b), (1c) greifen oder die Plättchen (14) zwischen den Spulenwindungen (9) liegen.

5. Vorrichtung nach einem der Ansprüche 1 bis 4, **dadurch gekennzeichnet, dass** mindestens zwei Stabilisierungselemente (3a), (3b), (3c) (3d) vorhanden sind.

6. Vorrichtung nach einem der Ansprüche 1 bis 5, **dadurch gekennzeichnet, dass** mindestens eine nutförmig Einkerbung (4) an den Stabilisierungselementen (3a), (3b), (3c), (3d) vorhanden ist.

7. Vorrichtung nach einem der Ansprüche 1 bis 6, **dadurch gekennzeichnet, dass** die Stabilisierungselemente (3a), (3b), (3c), (3d) mindestens ein Plättchen (14) aufweisen.

8. Vorrichtung nach einem der Ansprüche 1 bis 7, **dadurch gekennzeichnet, dass** die vertikalen Schienen (6a), (6b), (6c), (6m) der Stromzuführungsschienen (2a), (2b), (2c), (2m) außerhalb der Züchtungskammer (10) mit der Energieversorgungseinrichtung (13) elektrisch verbunden sind.

9. Vorrichtung nach einem der Ansprüche 1 bis 8, **dadurch gekennzeichnet, dass** eine Stromzuführungsschiene (2m) zwei horizontale Schienen (5m, 5n) aufweist, die mit den Spulen elektrisch verbunden ist.

10. Vorrichtung nach einem der Ansprüche 1 bis 9, **dadurch gekennzeichnet, dass** die Spulenwindungen (9) einen Windungsquerschnitt (Q) mit einer Windungsbreite (B) und einer Windungshöhe (H) im Verhältnis von 10:1 1 bis 1:10 aufweisen.

11. Vorrichtung nach Anspruch 10, **dadurch gekennzeichnet, dass** die Spulenwindungen (9) einen Windungsquerschnitt (Q) mit der Windungsbreite (B) und der Windungshöhe (H) im Verhältnis von 5:1 aufweisen.

## Claims

1. A device for producing crystals from electroconductive melts, comprising at least a crucible (12) that is arranged in a growth chamber (10) and contains a melt (11), a heating device (1) surrounding the crucible (12) and that is designed as a multiple coil arrangement of coils (1 a, 1 b, 1 c) placed on top of each other, wherein the coils (1 a, 1 b, 1 c) comprise step-shaped or continuous coil windings (9) and current supply rails (2a, 2b, 2c, 2m), which are electrically connected to a power supply device (13) arranged outside the growth chamber (10), are attached to the coils (1 a, 1 b, 1 c), **characterized in that**
the heating device (1) comprises stabilizing elements (3a), (3b), (3c), (3d) on the coil windings (9) and the current supply rails (2a), (2b), (2c), (2m) comprise at least one horizontal rail (5a, 5b, 5c, 5m) and one vertical rail (6a, 6b, 6c, 6m), which are connected to each other in the form of an angular part, wherein the horizontal rail (5a, 5b, 5c, 5m) is electrically connected to at least one coil (1 a, 1 b, 1 c) and a rail length (7) of the horizontal rail (5a, 5b, 5c, 5m) corresponds to at least one penetration depth of the magnetic flux at a frequency used in each case.

2. A device according to claim 1, **characterized in that** the stabilizing elements (3a), (3b), (3c), (3d) are designed as cylindrical rods with groove-shaped notches (4).

3. A device according to claim 1 or 2, **characterized in that** the stabilizing elements (3a), (3b), (3c), (3d) are designed as cylindrical rods provided with small plates (14).

4. A device according to claims 1 to 3, **characterized in that** the stabilizing elements (3a), (3b), (3c), (3d) are arranged coaxially along the outside of the coils between the current supply rails (2a), (2b), (2c), (2m), wherein the groove-shaped notches (4) engage the coil windings (9) of the coils (1 a), (1 b), (1 c) or the small plates (14) are positioned between the coil windings (9).

5. A device according to any one of claims 1 to 4, **characterized in that** at least two stabilizing elements (3a), (3b), (3c) (3d) are provided.

6. A device according to any one of claims 1 to 5, **characterized in that** at least one groove-shaped notch (4) is provided on the stabilizing elements (3a), (3b), (3c), (3d).

7. A device according to any one of claims 1 to 6, **characterized in that** the stabilizing elements (3a), (3b), (3c), (3d) comprise at least one small plate (14).

8. A device according to any one of claims 1 to 7, **characterized in that** the vertical rails (6a), (6b), (6c), (6m) of the current supply rails (2a), (2b), (2c), (2m) are electrically connected to the power supply device (13) outside the growth chamber (10).

9. A device according to any one of claims 1 to 8, **characterized in that** a current supply rail (2m) comprises two horizontal rails (5m, 5n), which are electrically connected to the coils.

10. A device according to any one of claims 1 to 9, **characterized in that** the coil windings (9) have a winding cross-section (Q), wherein the ratio of a winding width (B) to a winding height (H) ranges from 10:1 to 1:10.

11. A device according to claim 10, **characterized in that** the coil windings (9) have winding cross-section (Q), wherein the ratio of the winding width (B) to the winding height (H) is 5:1.

## Revendications

1. Dispositif de culture de cristaux à partir de bains fondus électriquement conducteurs, présentant au moins un creuset (12) disposé dans une chambre de culture (10) et contenant un bain fondu (11), un équipement de chauffage (1) entourant le creuset (12) étant réalisé sous forme de bobines (1a, 1b, 1c) disposées les unes sur les autres en tant qu'agencement de bobines multiples, les bobines (1a, 1b, 1c) présentant des spires de bobine (9) en échelons ou sans échelons, et des barres d'alimentation électrique (2a, 2b, 2c, 2m) étant mises en place sur les bobines (1a, 1b, 1c) et étant raccordées électriquement à un équipement d'alimentation en énergie (13) disposé à l'extérieur de la chambre de culture (10), **caractérisé en ce que** l'équipement de chauffage (1) présente des éléments de stabilisation (3a), (3b), (3c), (3d) sur les spires de bobine (9), et **en ce que** les barres d'alimentation électrique (2a), (2b), (2c), (2m) présentent au moins un rail horizontal (5a, 5b, 5c, 5m) et un rail vertical (6a, 6b, 6c, 6m) qui sont raccordés l'un à l'autre sous forme de pièce d'angle, le rail horizontal (5a, 5b, 5c, 5m) étant raccordé de façon électriquement conductrice à au moins une bobine (1a, 1b, 1c), et une longueur de bobine (7) du rail horizontal (5a, 5b, 5c, 5m) correspondant au moins à une profondeur de pénétration du flux magnétique pour une fréquence respectivement utilisée.

2. Dispositif selon la revendication 1, **caractérisé en ce que**
les éléments de stabilisation (3a), (3b), (3c), (3d) sont constitués en tant que barres cylindriques avec des encoches (4) en forme de rainure.

3. Dispositif selon la revendication 1 ou 2, **caractérisé en ce que**
les éléments de stabilisation (3a), (3b), (3c), (3d) sont constitués en tant que barres avec des plaquettes (14).

4. Dispositif selon les revendications 1 à 3, **caractérisé en ce que** les éléments de stabilisation (3a), (3b), (3c), (3d) sont disposés de façon coaxiale le long du côté extérieur de bobines entre les barres d'alimentation électrique (2a), (2b), (2c), (2m), les encoches (4) en forme de rainure s'engageant dans les spires de bobine (9) des bobines (1a), (1b), (1c), ou les plaquettes (14) étant situées entre les spires de bobine (9).

5. Dispositif selon une des revendications 1 à 4, **caractérisé en ce qu'**au moins deux éléments de stabilisation (3a), (3b), (3c), (3d) sont présents.

6. Dispositif selon une des revendications 1 à 5, **caractérisé en ce qu'**au moins une entaille (4) en forme de rainure est présente sur les éléments de stabilisation (3a), (3b), (3c), (3d).

7. Dispositif selon une des revendications 1 à 6, **caractérisé en ce que** les éléments de stabilisation (3a), (3b), (3c), (3d) présentent au moins une plaquette (14).

8. Dispositif selon une des revendications 1 à 7, **caractérisé en ce que** les rails verticaux (6a), (6b), (6c), (6m) des barres d'alimentation électrique (2a), (2b), (2c), (2m) sont raccordés électriquement à l'équipement d'alimentation en énergie (13) à l'extérieur de la chambre de culture (10).

9. Dispositif selon une des revendications 1 à 8, **caractérisé en ce qu'**une barre d'alimentation électrique (2m) présente deux rails horizontaux (5m, 5n) qui sont raccordés électriquement aux bobines.

10. Dispositif selon une des revendications 1 à 9, **caractérisé en ce que** les spires de bobine (9) présentent une section transversale de spire (Q) avec une largeur de spire (B) et une hauteur de spire (H) qui affichent un rapport de 10:1 à 1:10.

11. Dispositif selon la revendication 10, **caractérisé en ce que** les spires de bobine (9) présentent une section transversale de spire (Q) avec la largeur de spire (B) et la hauteur de spire (H) qui affichent un rapport de 5:1.
